(19) Europäisches Patentamt
European Patent Office
Office européen des brevets

(11) Numéro de publication: **0 023 471**
**B1**

(12) **FASCICULE DE BREVET EUROPEEN**

(45) Date de publication du fascicule du brevet: **11.07.84**

(51) Int. Cl.³: **C 03 C 17/245,**
**C 23 C 11/08**

(21) Numéro de dépôt: **80810236.2**

(22) Date de dépôt: **28.07.80**

(54) **Procédé pour déposer sur un substrat de verre un revêtement adhérent d'oxyde d'étain.**

(30) Priorité: **31.07.79 CH 7033/79**

(43) Date de publication de la demande:
**04.02.81 Bulletin 81/5**

(45) Mention de la délivrance du brevet:
**11.07.84 Bulletin 84/28**

(84) Etats contractants désignés:
**BE CH DE FR GB IT LI LU NL SE**

(56) Documents cités:
**BE - A - 871 048**
**FR - A - 1 207 231**
**FR - A - 2 380 997**
**GB - A - 702 774**
**US - A - 2 566 346**

**Journal Tin, August 1976**
**JOURNAL OF THE ELECTRO-CHEMICAL SOCIETY, vol. 120, no. 5, mai 1973, J.A. ABOAF et al. "Chemical composition and electrical properties of tin oxide films prepared by vapour deposition", pages 701-702**

(73) Titulaire: **Societa Italiana Vetro - SIV - S.P.A**
**I-66050 San Salvo (Chieti) (IT)**

(72) Inventeur: **Kalbskopf, Reinhardt**
**103, Avenue du Bois de la Chapelle**
**CH-1213 Onex (CH)**
Inventeur: **Baumberger, Otto**
**18, rue des Caroubiers**
**CH-1227 Carouge (CH)**

(74) Mandataire: **Dousse, Blasco et al,**
**7, route de Drize**
**CH-1227 Carouge/Genève (CH)**

**EP 0 023 471 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

La présente invention a pour objet un procédé pour déposer, sur un substrat de verre porté à une température de 590°C environ à 650°C, un revêtement adhérent d'oxyde d'étain, de résistivité de $5.10^{-3}$ Ohm.cm ou moins. De préférence, le substrat est une plaque ou feuille de verre boro-silicié ou sodo-calcique.

L'article obtenu par la mise en oeuvre de ce procédé, qui est un vitrage électriquement conducteur convenant à un grand nombre d'applications industrielles, présente un revêtement ayant une transparence de 60 à 95% et une très basse résistivité spécifique puisque celle-ci est inférieure à $5.10^{-3}$ Ohm.cm, cette résistivité n'étant pas le fait d'un dopage du revêtement au fluor. Sa réflectivité I.R. est supérieure à 50% et le revêtement ne subit aucune altération notable lorsqu'on soumet un tel article à la trempe et à la flexion à chaud réalisées dans les conditions ci-après: pour la trempe, on chauffera le substrat à environ 700°C et on le refroidira ensuite à la cadence de 5 à 10°C/sec; pour la flexion, on chauffera l'article jusqu'à température de ramollissement en on le pliera, de préférence du côté où le revêtement est soumis à la compression. Lors de cette opération, on peut atteindre des rayons de courbure de l'ordre de 15 cm sans détérioration du revêtement conducteur.

L'utilisation d'oxyde d'étain pour rendre conducteur un substrat en verre ou en céramique est connu et a fait l'objet de nombreuses publications parmi lesquelles on peut citer: "Physical Properties of $SnO_2$ Materials" par Z. M. Jarzebski et J. P. Marton, J. Electrochem. Soc, *1976*, 199; 299c; 333c. "Chemical Vapor Deposition of Antimony-Doped Tin Oxide Films Formed from Dibutyl Tin Diacetate", par J. Kane, H. P. Schweizer, W. Kern, J. Electrochem. Soc. *1976, 123*, No 2, 270; "Composition and Conductivity of Tin Oxide Films Prepared by Pyrohydrolytic Decomposition of Tin(IV) Compounds", par H. Kim et H. A. Laitinen, J. Amer. Ceramic Soc. *58,* 23 (1975); brevet belge No 869.062. Dans ce dernier, on décrit un vitrage recouvert d'un revêtement dont la résistance ($R_\square$) est inférieure à 50 Ω et présentant un taux élevé de réflexion dans l'IR. Le brevet ne donne cependant aucune indication précise sur la réalisation d'un tel vitrage et cette divulgation ne contribue donc en rien à l'avancement de la technique. Ainsi, jusqu'à présent, on n'était pas parvenu à fabriquer un vitrage conducteur ayant les propriétés électriques et optiques de celui de l'invention et, de plus, pouvant résister sans s'altérer, simultanément aux opérations de trempe et de façonnage requises dans la fabrication de vitrages pour le bâtiment et l'automobile. En effet, les revêtements d'oxyde d'étain connus manquent soit de conductibilité, soit de transparence ou sont trop fragiles pour supporter les contraintes mécaniques et thermiques provoquées par la trempe et la mise en forme des panneaux de verre sur lesquels ils sont appliqués. Ces défauts sont maintenant été éliminés grâce au procédé de l'invention qui fait appel à la techniques dite CVD (Chemical Vapor Deposition) et qui consiste à faire réagir, à la surface du verre chauffé, un composé d'étain volatil avec de la vapeur d'eau et un réactif réducteur.

Il existe à l'heure actuelle divers procédés et dispostifs destinés au recouvrement d'un substrat, par exemple une plaque de verre, par une couche conductrice d'oxyde d'étain, couche devant présenter à la fois une transparence assez semblable à celle du substrat, une résistivité électrique relativement réduite et une résistance mécanique élevée.

C'est ainsi que, parmi d'autres procédés, on a notamment déjà fait usage à cet effet de la technique de dépôt en phase vapeur (CVD). On connaît en particulier, de l'article de H. Koch "Elektrische Untersuchungen an Zinndioxydschichten" (voir Phys. Stat. 1963, Vol. 33, pages 1059 et 55) un procédé en un dispositif pour déposer une couche mince de $SnO_2$ sur une plaquette de verre par réaction de $SnCl_4$ et de $H_2O$ amenés sous forme diluée dans un gaz porteur, en l'occurrence de l'air, en contact mutuel avec la surface de la plaquette de verre préalablement chauffée à une température de l'ordre de 200 à 400°C. Ces deux réactifs gazeux sont projetés sur le verre par l'intermédiare d'une buse à deux tuyères coaxiales, dont la tuyère centrale reçoit la dilution gazeuse de $SnO_2$ alors que la tuyère externe est alimentée par la dilution gazeuse de $H_2O$.

On a également proposé un procédé et un dispositif très similaires aux précédents, notamment dans la demande de brevet allemand publiée avant examen No 2.133.274, permettant, de plus, d'obtenir un dopage, par le l'antimoine, de la couche de $SnO_2$ déposée sur un substrat, en l'occurrence également une plaquette de verre, en vue de réduire la résistivité électrique de cette couche. A cet effet, il a notamment été fait emploi, de plus, de $SbCl_3$ ou $SbCl_5$ sous forme diluée dans un gaz porteur, ici de l'azote, qui est porté en présence de $SnCl_4$ et de $H_2O$ au-dessus du substrat, par l'intermédiaire d'une buse à trois tuyères coaxiales recevant chacune l'un des composants ci-dessus. La réaction de combinaison s'effectue ainsi à proximité du substrat et à une certaine distance des trois tuyères de la buse. On peut également citer les brevets US 3,850,679; 3,888,649 et le brevet britannique numéro 1,507,996.

Par ailleurs, il est connu que l'apport d'un composé réducteur à la réaction de formation de l'oxyde d'étain à partir d'un composé d'étain et de vapeur d'eau améliore la conductibilité de la couche qui en résulte. Ainsi Kuznetsov (Fizika Fverdogo Tela, Vol. *2*, No 1, 35—42 (1960) décrit l'hydrolyse de $SnCl_4$ en solution dans l'alcool par pulvérisation d'eau et d'une telle solution sur une surface portée à 500°C, la conductivité de la couche ainsi obtenue (3 $\mu$m) étant de $10^{-2}$ $\Omega^{-1}$, c'est-à-dire une résistivé $\rho$ de l'ordre de $10^{-2}$ Ω.cm. La transparence d'un revêtement obtenu dans de telles conditions n'est cependant pa satisfaisante.

Les raisons pour lesquelles l'apport d'un composé réducteur qui, vraisemblablement, transforme une partie de l'étain tétravalent en étain bivalent et améliore la conductibilité de sont pas très claires car il semble peu probable qu'il se forme, dans un tel cas, du Sn métallique dont la présence serait facilement décelable car elle conduirait à une opacification de la couche transparente. Il ne semble par contre pas exclu que $SnO_2$ puisse former, avec le SnO résultant de la réduction, une molécule excitée électroniquement déficiente (par exemple $Sn_2^{IV}O_3^{++}$) dont la présence améliorerait la conductibilité par transfert de trous (hole conductivity).

Quoiqu'il en soit exactement, on a constaté que lorsqu'on fait appel, comme mentionné plus haut, à la technique de CVD pour la réaction entre $SnCl_4$ et $H_2O$, l'apport d'alcool comme composé réducteur en simple mélange avec le $SnCl_4$ ne fournit pas des couches conductrices de propriétés très sensiblement améliorées ce qui indique d'un pré-mélange des réactifs ne convient pas.

Suivant le procédé de l'invention, on opère au moyen d'un gaz porteur contenant, en volume, au moins 30% d'hydrogène, lequel provoque une réduction partielle du $SnO_2$ ou des réactifs lors de leur réaction sur le substrat.

Il fait noter, à ce stade, que l'utilisation d'hydrogène lors des opérations de dépôt $SnO_2$ par CVD n'est pas, en soi, inconnue. En effet, dans le Journal of the Electrochemical Society *120* (5), 701—2 (1973), on décrit le dépôt par CVD de couches de $SnO_2$ sur un substrat en silicium oxydé. Les réactifs sont du $SnCl_4$ et de la vapeur d'eau et le gaz porteur est l'azote. Dans cet article, s'il est indiqué que la réaction a été effectuée non seulement dans une atmosphère d'azote, mais notamment aussi dans une atmosphère d'hydrogène, la résistivité du revêtement obtenu dans ce dernier cas s'est révélée être supérieure d'un ordre de grandeur par rapport à celle d'un revêtement déposé dans une atmosphère d'azote. Par ailleurs, même si les valeurs de résistivité citées sont très basses, il convient de relever que celles-ci se réfèrent à des revêtements de $SnO_2$ obtenus sur un substrat ne contenant pas de ions sodium. Or, il est bien connu (voir en particulier l'article "Chemical Vapor Deposition of Transparent, Electrically Conductive Tin Oxide Films Formed from Dibutyl Tin Diacetate", pages 1114 à 1149, paru en août 1979 dans la revue "Journal of the Electrochemical Society") que la résistivité d'une couche de $SnO_2$ déposée sur du verre, notamment du verre à vitres, est très supérieure (10 fois et plus) à la résistivité d'une couche similaire déposée dans les mêmes conditions opératoires sur un substrat très faiblement sodique tel un verre boro-silicié ou même sur du quartz (qui est évidemment dépourvu de ions sodium). D'autre part, le brevet français 1.207.231 (Philips) décrit un procédé pour déposer par CVD, sur un substrat, des couches d'oxydes métalliques et, notamment, du $SnO_2$ où interviennent du $SnCl_4$, le la vapeur d'eau et, éventuellement, de l'hydrogène, ce dernier gaz étant destiné à former l'eau nécessaire à l'hydrolyse du tétrachlorure stannique par réaction avec de l'oxygène (celui de l'air par exemple). Les exemples de ce brevet indiquent cependant que le pourcentage d'hydrogène du mélange gazeux utilisé est relativement faible (environ 7,5%) et nettement inférieur à celui des mélanges convenant à la présente invention où, au minimum, 30% d'hydrogéne dans le volume gazeux sont nécessaire pour assurer au revêtement de $SnO_2$ une résistivité suffisamment faible.

Enfin, l'article "Conveyor Furnace Produces Tin Oxide Coated Devices", publié en août 1976 dans le journal "Tin", mentionne la possibilité de produire un revêtement de $SnO_2$ sur du verre, par la technique du CVD et par réaction de $SnCl_4$ et de $H_2O$ dilués dans de l'azote, en faisant emploi d'une faible quantité (environ 4,3% v/v) de méthanol à titre de réducteur.

On a déjà proposé d'obtenir des revêtements de $SnO_2$ bien moins résistifs par dopage de tels revêtements à l'antimoine et surtout au fluor. Les meilleurs résultats ont été obtenus en faisant intervenir des composés fluorés lors de la réaction de combinaison produisant le dépôt de $SnO_2$. Toutefois ces résultats n'ont pu être obtenus qu'en faisant intervenir une quantité particulièrement importante de composés fluorés, tellement importante même qu'elle peut constituer un danger pour la santé des personnes appelées à mettre en oeuvre un tel procédé. Les prevets FR 2.380.997 et BE 871.408 décrivent précisément une telle technique.

La présente invention, qui a pour but d'obvier aux inconvénients ci-dessus, propose à cet effet un procédé pour déposer sur un substrat de verre, porté à une température de 590°C environ à 650°C, un revêtement adhérent d'oxyde d'étain de résistivité de $5 \cdot 10^{-3}$ Ohm.cm ou moins suivant lequel on projette sur ce substrat, sous forme de courants de gaz laminaires se réunissant à proximité immédiate d'une portion de la surface du substrat, un composé volatil d'étain et de la vapeur d'eau dilués l'un et l'autre dans un flux propre de gaz porteur qui contient au moins 30% d'hydrogène (v/v), et suivant lequel on déplace le substrat par rapport ausdits courants de manière à obtenir le revêtement par formation d'un dépôt homogène d'oxyde d'étain successivement sur des zones renouvelées et jointives de la surface du substrat. On peut, dans certains cas spéciaux utiliser jusqu'à 80% d'hydrogène ou même de l'hydrogène pratiquement pur, par exemple à 99,9%.

Comme composé d'étain, on emploie de préférence $SnCl_4$ pur ou dissous dans un solvant inerte, mais on peut utiliser d'autres composés d'étain volatils, par exemple du type $Sn(Alk)_4$ ou Alk désigne un radical alcoyle inférieur et l'étain dibutyle-diacétyle.

Selon une variante de mise en oeuvre du procédé ci-dessus et en vue d'obtenir un revêtement d'oxyde d'étain particulèrement clair et lisse, on ajoutera au mélange de gaz de la réaction du gaz fluorhydrique, ce dernier étant fourni en mélange avec de l'eau en proportion de 0,1 à 5% en poids de celle-ci.

Selon une autre variante de mise en oeuvre de ce procédé, on pourra, après obtention d'une première couche d'oxyde d'étain, répéter l'opération de dépôt une seconde fois ou plusieurs fois de suite, le revêtement obtenu étant ainsi formé par la superposition de deux ou de plusieurs couches d'oxyde d'étain ayant chacune une épaisseur de 10 à 500 nm.

Le dessin annexé représente, à titre d'exemple et très schématiquement, une forme d'exécution de l'installation pour la mise en oeuvre du procédé, objet de la présente invention:

— la figure 1 en est une vue d'ensemble,
— la figure 2 est une perspective, avec coupe verticale, à plus grande échelle, d'un élément de l'installation de la figure 1.

L'installation visible au dessin est destinée à déposer par la technique CVD et sur un substrat, en l'occurrence une feuille de verre V portée à haute température, une couche d'oxyde d'étain $SnO_2$ en tirant profit de la réaction chimique suivante:

$$SnCl_4+2H_2O \rightarrow SnO_2+4HCl$$

A cet effet, cette installation comprend tout d'abord une suite de rouleaux 1, sur lesquels est possée et se déplace en direction F la feuille V, rouleaux qui sont entraînés en rotation dans le sens antihoraire par un moteur électrique (non représenté) et qui présentent, bien entendu, une longueur compatible avec la largeur de la feuille de verre à supporter. La vitesse de rotation des rouleaux I sera choisie de manière que le déplacement de la feuille V s'effectue avec une vitesse linéaire de quelques mètres par minute, de l'ordre de 1 à 15 selon les cas. Bien entendu cette gamme de vitesse n'est donnée ici qu'à titre indicatif. Si nécessaire, on peut prévoir des vitesses de déplacement du verre beaucoup plus élevées.

Au-dessus de cette suite de rouleaux 1, l'installation représentée présente une buse 2 dont le profil structurel de principe fait l'objet de la figure 2 à laquelle on se réfère dès maintenant. Cette buse comporte en effet trois tuyères distinctes 3, 4 et 5 respectivement, s'étendant longitudinalement en direction parallèle aux rouleaux I déjà cités, sur une longueur correspondant à la largeur de la feuille de verre V. De telles tuyères pourront donc même présenter une longueur de plusieurs mètres. Comme on le voit au dessin, les tuyères 3 à 5 sont formées par assemblage de profilés longilignes 6a et 6b, 7a et 7b, 8a et 8b, eux-mêmes fixés par tous moyens adéquats, à deux paires de profilés 9a et 9b, respectivement 10a et 10b délimitant entre-eux des passages 11, 12 et 13 en liaison avec les tuyères 3, 4 et 5 respectivement.

Les parois latérales 3a et 3b, 4a et 4b, 5a et 5b des tuyères 3 à 5 convergent vers une ligne commune L distante du plan contenant la face inférieure des profilés 6a et 6b d'une longueur de l'ordre de 3 à 6 mm par exemple. En outre, les ouvertures de sortie des tuyères 3, 4 et 5, qui se présentent sous forme de trois fentes oblongues s'étendant sur toute la longueur des profilés 6a, 7a, 7b et 6b, ont une largeur de quelques dixièmes de millimètres, par exemple 1/10 à 5/10 environ.

La largeur de la face inférieure des profilés 6a et 6b sera, de préférence, comprise entre 10 et 20 fois la largeur totale des fentes de sortie des tuyères 3 à 5.

De préférence, mais non exclusivement, cette face inférieure des profilés 6a et 6b sera couverte d'une couche d'un métal chimiquement inerte ou d'un alliage de tels métaux ou encore d'oxydes métalliques. A titre d'exemple, ce métal peut être de l'or ou du platine. Les oxydes pourraient être choisis parmi $SnO_2$, $SiO_2$ ou $Al_2O_3$. Bien entendu, si ce n'était par des raisons de prix de revient, on pourrait prévoir ces organes en métal inerte massif.

En effet, les métaux et alliages usuels, tels l'acier ou le laiton, présentent, en présence d'hydrogène, des priorités catalytiques susceptibles de gêner le contrôle de la réaction désirée pour obtenir ou dépôt de $SnO_2$ offrant les qualités mécaniques, physiques et optiques désirées.

Bien entendu, l'assemblage de profilés constituant la buse 2 est recouvert, à chaque extrémité, d'une plaque d'obturation, non représentée, montée de manière à assurer une étanchéité totale et à former ainsi des tuyères 3, 4 et 5 et des passages 11, 12 et 13 qui soient bien fermés latéralement. Des canaux 14a et 14b ménagés dans la partie supérieure des profilés 10a et 10b, sur toute la longueur de ceux-ci, permettent d'établir une circulation d'un fluide, par exemple de l'huile, destiné au maintien de la buse 2 à une température optimum de fonctionnement.

Une autre plaque 15 recouvre la face supérieure de la buse 2 sur toute son étendue et de façon étanche empêchant ainsi toute communication entre les passages 11, 12 et 13.

On signalera encore que le profil général et l'état de surface des parois délimitant tant les tuyères 3 à 5 que les passages 11 à 13 (fig. 2) ainsi que les sections transversales de ceux-ci sont tels que, pour des débits gazeux de l'ordre de 3 à 6 litres/h par centimètre de longueur de la buse, les écoulements à la sortie des buses soient de type "laminaire".

De part et d'autre de la buse 2, et sur toute la longueur de celle-ci, l'installation représentée comporte deux caniveaux d'aspiration 16 et 17 (fig. 1 et 2), de section droite carrée et dont la face inférieure est coplanaire avec la face inférieure des profilés 6a et 6b précédemment décrits. Ces caniveaux présentent chacun deux fentes longitudinales 16a et 16b, pour le caniveau 16,

respectivement 17a et 17b, pour le caniveau 17. Ces caniveaux sont reliés, par un système de conduits 18, à l'entrée d'une pompe aspirante 19 branchée, par la sortie, au bas d'une tour de lavage 20 remplie de matériaux réfractaires (anneaux de Raschig).

L'installation représentée comprend, de plus, deux récipients barboteurs thermostatisés, 21 et 22 contenant, le premier du chlorure d'étain $SnCl_4$ liquide et le second du méthanol, deux débitmètres 23 et 24 présentant une vanne de réglage du débit, 23a et 24a, alimentés par un mélange d'axote et d'hydrogène en proportion variant de 20/80 à 80/20, deux vannes 25 et 26 disposées sur des tubulaires 27 et 28 reliant les débitmètres aux récipients barboteurs ci-dessus. Deux conduits 29 et 30 relient la sortie des récipients 21 et 22 respectivement au passage 13 et aux passages 11 et 12 de la buse 2, c'est-à-dire en définitive à la tuyère 5 de cette buse, pour le conduit 29, et aux tuyères 3 et 4, pour le conduit 30.

Les conduits 29 et 30 traversent une enceinte, représentée schématiquement par un contour en trait mixte, contenant un liquide ce chauffage par exemple de l'huile, maintenu à une température constante d'environ 110°C de toute manière adéquate.

L'installation comprend encore un récipient 31 contenant de l'eau, celle-ci étant pompée suivant un débit mesurable aved précision par une pompe doseuse 32 et injectée dans un évaporateur 33 porté à une température supérieure à 100°C.

L'évaporateur 33 est également alimenté en un mélange $N_2/H_2$ en proportion 20:80 à 80:20 par l'intermédiaire d'un rotamètre 34 et en gaz fluorhydrique, par l'intermédiaire du rotamètre 35 dont la tubulure 36 de sortie aboutit en un point 37 situé entre la pompe 32 et l'évaporateur 33. L'installation comprend encore une canalisation 38 pour l'amenée du mélange de vapeur d'eau/HF (environ 98:2 à 99:1) et des vannes 39 et 40 permettant de régler des débits respectifs des dilutions de $H_2O$/HF et de méthanol ou même d'exclure l'une d'eux complètement.

L'installation qui vient d'être décrite permet de revêtir, par exemple, une plaque de verre par un dépôt d'oxyde d'étain, d'une épaisseur de l'ordre de 0,5 à 3 $\mu$m, présentant à la fois une très bonne transparence, une résistivité électrique relativement réduite, une adhérence remarquable au verre et une résistance mécanique et aux acides élevée.

Une installation expérimentale de ce type munie d'une buse de 50 cm de longueur, dont l'ouverture des tuyères 3, 4 et 5 avait une largeur de 0,1—0,1 et 0,2 mm, a permis de traiter une plaque de verre de 50 cm de large et de 4 mm d'épaisseur chauffée à 600°C environ et entraînée en direction F (fig. 1 et 2) à une vitesse de 2 m/mn. La distance séparant la face inférieure de la buse et la surface du verre était de 4 mm.

Il a été fait usage de récipients ayant une capacité d'environ un litre de $SnCl_4$ pour le récipient 21, et un litre de $H_2O$ pour le récipient 31 respectivement. Le récipient 21 a été chauffé à une température convenable pour que, avec un débit de gaz porteur $N_2/H_2$ de 60 litres/heure pour le récipient 21 et de 120 litres/heure pour l'évaporateur 33, avec un débit de la pompe 32 de une mole d'$H_2O$ par heure, on obtienne un débit de 2 mole/h de chlorure d'étain. En outre, on a maintenu la température de la buse à une valeur de 110°C environ par circulation d'huile dans les canaux 14a et 14b de celle-ci (fig. 2).

Compte tenu du profil donné aux tuyères 3, 4 et 5 de la buse 2, et en particulier au fait qu'elles convergent par leurs parois latérales vers une ligne commune *l*, les écoulements gazeux sortant de ces ajutages, écoulement de $SnCl_4$ pour la tuyère 5 et de vapeur d'$H_2O$ pour les tuyères 3 et 4, qui sont laminaires entrent en contact mutuel d'abord en s'effleurant tangentiellement puis toujours plus directement au fur et à mesure qu'on se rapporche de la ligne L ci-dessus. Bien entendu, l'écoulement combiné de ces trois flux gazeux devient d'autant moins laminaire que s'effectue l'interpénétration de ces flux. Celle-ci n'a toutefois véritablement lieu qu'à proximité immédiate de la surface du verre V, laquelle est chauffée à 600°C environ comme décrit, de sorte que la réaction de combinaison:

$$SnCl_4 + 2H_2O \rightarrow SnO_2 + 4HCl\nearrow$$

se produit sur le verre. Il convient à ce point de signaler que, si on ne prenait pas de mesure particulière, cette réaction s'effectuerait de façon très violente avec production d'une grande quantité d'oxyde d'étain, $SnO_2$ et des hydrates du type $SnO_2 . nH_2O$, à la sortie des tuyères 3 à 5 de la buse 2, d'où risque de bouchage partiel ou total des tuyères, avec dépôt de des mêmes oxydes d'étain sur le verre sous forme d'un voile blanc et non pas sous forme de la couche semi-conductrice transparente désirée.

Avec l'installation décrite, ce risque a été écarté en ajoutant un agent réducteur aux deux écoulements gazeux de $SnCl_4$ et de vapeur d'$H_2O$, sous la forme de l'$H_2$ inclus dans le gaz porteur. L'hydrogène est en effet un gaz réducteur vis-à-vis du $SnCl_4$, modérateur de l'hydrolyse et de plus, il agit comme catalyseur.

La réaction de combinaison de $SnCl_4$ et de $H_2O$ ne s'effectue pas seulement dans la zone centrale de la buse 2, c'est-à-dire à proximité de la partie de cette buse dans laquelle s'ouvrent les tuyères 3, 4 et 5. En effet, cette réaction a lieu alors que la pompe 19 fonctionne de sorte que, par les caniveaux 16 et 17 disposés de part et d'autre de la buse, il se crée une dépression aux extrémités droite et gauche, au dessin, de l'espace compris entre la plaque de verre V et la face inférieure des profilés 6a et 6b et la buse. De ce fait, il se forme, dans cet espace, un écoulement gaaeux allant de la partie centrale de cet

espace vers les caniveaux 16 et 17 déja cités. Cet écoulement contient surtout une part de $SnCl_4$ et de $H_2O$ dispersés dans le gaz porteur et n'ayant pas encore réagi, les vapeurs de HCl déjà formées, une certaine quantité de gaz porteur débarassé des réactifs qui ont déjà réagi. Ainsi, la réaction entre $SnO_2$ et $H_2O$ peur se continuer avec les gaz réactifs résiduels fur une certaine longueur, de part et d'autre de la ligne L de convergence des tuyères.

La puissance de l'aspiration réalisée grâce aux caniveaux 16 et 17 est choisie de manière que les gaz réactifs issus de la buse 2 ne subsistent dans cet espace que pendant le temps strictement nécessaire à l'obtention d'un dépôt de $SnO_2$ sur le verre, dépôt qui se présente sous forme d'une couche transparente et non sous forme d'une croissance de $SnO_2$ en poudre. Bien entendu, l'aspiration ne doit pas non plus être drop forte car, autrement, les gaz réactifs issus de la buse n'auraient pas le temps d'atteindre la surface du verre. L'intensité de l'aspiration est donc déterminante en ce qui concerne la qualité et la vitesse de croissance de la couche. On signalera de plus que, grâce à cette aspiration, on isole en quelque sorte de l'atmosphère ambiante l'espace compris entre la buse et la plaque de verre, espace dans lequel a lieu la réaction désirée, et on empêche, d'une part, toute pénétration éventuelle dans cet espace d'humidité supplémentaire susceptible d'influencer la réaction de combinaison et, d'autre part, tout échappement vers cette même atmosphère ambiante, de vapeurs nocives, par exemple de HCl, ou d'hydrogène, l'air ambient ayant tendance à affluer vers les fentes 16a et 16b, respectivement 17a et 17b en passange entre le caniveau 16, respectivement le caniveau 17, la plaque de verre V et la buse 2.

Les produits gazeux aspirés grâce à la pompe 19 sont dirigés, comme décrit, vers la tour de lavage 20, de manière que les acides résiduels volatils subissent une percolation et un entraînement par de l'eau, la solution acide résultante étant séparée des gaz lavés et évacuée par le conduit 20a.

Dans les conditions opératoires ci-dessus, le rendement réactionnel a été d'environ 70%. Le verre a été revêtu sur toute sa surface d'une couche de $SnO_2$ présentant une épaisseur de 0,5 à 3 $\mu$m, une transparence de 60 à 95% selon les échantillons, et une résistance moyenne de $R_\square$=1 à 10 Ω, de préférence de 2 à 5 Ω pour 1 à 3 $\mu$m d'épaisseur.

En outre, la couche de $SnO_2$ ainsi obtenue s'est avérée avoir une dureté particulièrement élevée, supérieure à celle du verre sur laquelle elle avait été déposée. Sa résistance était ainsi très importante que ce soit aux sollicitations mécaniques les plus intenses, par exemple à l'impact, qu'à l'attaque par des acides. Ce verre a pu notamment être soumis à une opération de bombage avec un rayon de courbure de 15 cm, après en avoir porté la température entre 600 et 700°C, sans détérioration quelconque du revêtement de $SnO_2$. Il a également été possible de le tremper dans les conditions usuelles pour le verre normal, c'est-à-dire de le refroidir, à partir de 700°C, à la cadence de plusieurs °C par minute. Enfin, il est à remarquer qu'une plaque de verre revêtue d'une couche de $SnO_2$, dans les conditions et selon les modalités décrites, peut être coupée au diamant en attaquant soit l'avers, soit le revers de la plaque sans écaillage de la couche.

Avec cette même installation et sous des conditions opératoires ne différant de celles indiquées que en ce qui concerne la vitesse d'entraînement de la plaque V, cette vitesse ayant été portée à environ 10 m/mm, on a obtenu un dépôt de $SnO_2$ présentant une épaisseur d'environ 0,1 $\mu$m, une résistance moyenne de $R_\square$=500 Ω, c'est-à-dire une résistivité de $5 \cdot 10^{-3}$ Ohm.cm, une transparence de presque 100% pour le rayonnement visible et des propriétés mécaniques pratiquement équivalentes à celles du dépôt obtenu en entraînant la plaque de verre à une vitesse de 2 m/mn.

L'adjonction directe de $H_2$, en vue d'atténuer la violence de la réaction de combinaison du $SnCl_4$ et de la vapeur de $H_2O$, n'est pas la seule mesure possible. Selon une variante de mise en action du procédé selon l'invention, il est possible de faire usage d'un gaz porteur constitué par de l'azote exclusivement et de produire in situ l'hydrogène nécessaire à la réduction à partir d'un solvant volatif hydrocompatible tel que le méthanol $CH_3OH$. Dans un tel cas, on fera appel à la contribution du récipient barboteur 22, le méthanol étant entraîné suivant un débit controlable par la vanne 40, par du $N_2$ seul. Dans ce cas, le gaz porteur traversant l'évaporateur 33 sera également du $N_2$.

Compte tenu de la température relativement élevée règnant à la sortie des tuyères, le méthanol peut se décomposer selon la réaction:

$$CH_3OH \rightarrow 2H_2 + CO$$

Il peut également réagir avec $H_2O$ selon la réaction:

$$CH_3OH + H_2O \rightarrow 3H_2 + CO_2$$

Dans un cas comme dans l'autre, on a donc production in situ de l'hydrogène nécessaire au contrôle de la réaction essentielle déjà citée:

$$SnCl_4 + 2H_2O \rightarrow SnO_2 + 4HCl$$

Il convient de signaler que l'expérimentation n'a pas permis de déterminer quelle était quelle des deux réactions ci-dessus concernant $CH_3OH$ qui était préférentielle. Il a toutefois été remarqué que,

dans les conditions opératoires ci-après, l'introduction du méthanol dans le processus de dépôt de la couche de $SnO_2$ désirée permettait effectivement de contrôler ce processus de même manière que dans le cas d'utilisation d'hydrogène mélangé à l'azote en tant que gaz porteur (fig. 1). Bien entendu, si désiré, on peut faire usage simultanément du mélange $N_2/H_2$ pour entraîner l'eau et HF et de méthanol dilué par $N_2$, les débits respectifs des dilutions étant réglés par les vannes 39 et 40.

Pour obtenir avec la présente installation pilote et en présence de $CH_3OH$, une plaque de verre de 20 cm de large recouverte d'un dépôt transparent de $SnO_2$, on a fait passer dans les deux récipients 21 et 22 un débit d'environ 60 litres/heure d'azote, débits réglés par action sur les vannes 23a et 24a dont sont munis les débitmètres 23 et 24 et 60 litres/heure de $N_2$ dans l'évaporateur 33, la pompe 32 débitant 2 moles d'$H_2O$/heure. On a porté les flacons à des températures convenables pour que leurs débits en réactif correspondant soient respectivement de 1 mole/heure de $SnCl_4$ et 0,5 mole/heure de $CH_3OH$. La température de la buse, maintenue par circulation d'huile, était comme précédemment de 110°C alors que la plaque de verre avait été préchauffée à une température d'environ 600°C. Le verre a été entraîné en direction F à une vitesse de 2 m/mn tout en le maintenant à 6 mm de distance de la face inférieure des profilés 6a et 6b constitutifs de la buse.

Le revêtement de $SnO_2$ obtenu s'est révélé être pratiquement identique en épaisseur, qualité et caractéristique mécaniques, électriques ou physiques au revêtement analogue obtenu comme décrit plus haut sans méthanol.

Il est à noter qu'on peut parfaitement metrre en oeuvre l'invention sans faire usage du HF gazeux. Dans ce cas, le revêtement présente des propriétés électriques et de réflexion dans l'IR qui sont analogues à celles des revêtements obtenus en présence de HF. Cependant, il peut alors arriver que le verre ainsi revêtu ait un aspect légèrement moins clair et moins lisse que lorsqu'on travaille en présence de HF.

Lorsqu'on opère en présence de ce gaz, on peut également utiliser le HF directement en solution aqueuse dans le flacon servant à fournir la vapeur d'eau de la réaction. Comme proportion, on peut utiliser de 0,1 à 5% en poids de HF dans l'eau. Ainsi, un verre de 4 mm d'épaisseur, porté à une température d'environ 600°C a été recouvert d'une couche de 0,9 $\mu$m de $SnO_2$ traité au HF par passage au devant de la buse à une vitesse de 2 m/mn et à une distance d'environ 6 mm de celle-ci. Les débits de gaz porteur (un mélange de $N_2$ 40%-$H_2$ 60%) ont été de 60 litres/heure pour le $SnCl_4$ et la vapeur d'eau.

Le dépôt de $SnO_2$ obtenu suivant l'invention en présence de HF est particulèrement performant. En effet, dans le cas ci-dessus, sa résistance était de $R_\square = 4\ \Omega$, et son pouvoir réfléchissant à l'infrarouge de l'ordre de 75%.

En outre, sa transparence à la lumière visible était de 90% sa surface étant particulièrement lisse et ne provoquant pas de diffusion de la lumière (pas d'aspect laiteux). Les caractéristiques de résistance mécanique ont été, elles aussi, très élevées: le verre ainsi revêtu de $SnO_2$ traité au HF a pu subir un traitement thermique de trempe identique à ceux auxquels sont soumises traditionnellement certaines vitres de véhicules, par exemple les vitres latérales de voitures automobiles. Il a également été possible de bomber une telle plaque à chaud (température d'environ 650°C) avec des rayons de courbure de 15 cm sans modifier les caractéristiques du dépôt de $SnO_2$ traité au HF. De plus, une plaque de verre recouverte de la manière décrite a pu être travaillée de façon traditionnelle (découpage, meulage, etc.) sans que le dépôt n'ait été endommagé.

La couche de $SnO_2$ traité au HF présentait en effet une dureté supérieure à celle du verre qui le supportait et n'a pu être griffée, en outre, sa résistance chimique aux acides et sa résistance aux impacts se sont avérées particulièrement élevées. Par ailleurs, un tel verre résiste parfaitement au trempage suivant lequel on le refroidit à partir de 700°C, à la cadence de environ 5—10°C par seconde.

On signalera encore qu'une couche de $SnO_2$ traitée au HF déposée sur une plaque de verre dans les conditions citées peut être recouverte par de l'argent ou une peinture d'argent déposée à 600°C, par exemple envue de former des contacts électriques. Un tel dépôt d'argent adhère très bien à la surface du dépôt de $SnO_2$ avec environ 15 kg/$cm^2$.

Avec la présente installation et sous des conditions opératoires ne différant de celles indiquées ci-dessus que en ce qui concerne la vitesse d'entraînement de la plaque V, cette vitesse ayant été portée à environ 10 m/mn, on a obtenu un dépôt de $SnO_2$ traité au HF présentant une épaisseur d'environ 10 nm, une résistance moyenne de $R_\square = \sim 200\ \Omega$, une transparence de presque 100% pour le rayonnement visible, un pouvoir réfléchissant à l'infrarouge de 25% et des propriétés mécaniques identiques à celles obtenues avec le dépôt de $SnO_2$ également traité au HF par entraînement de la plaque de verre à une vitesse de 2 m/mn.

Les utilisations de plaques de verre de toutes dimensions recouvertes d'une couche de $SnO_2$ non traité ou traité au HF peuvent être très variées selon leurs performances de nature physique et électrique notamment.

Ainsi, une plaque de verre recouverte d'une couche de $SnO_2$ obtenue suivant l'invention peut être utilisée par exemple pour constituer des vitrages isolants pour fenêtre ou portes-fenêtres d'habitations, de navires ou de trains, compte tenu de sa haute transparence à la lumière visible, de sa faible émissivité et de son pouvoir réfléchissant à l'infrarouge relativement important. Une telle plaque

présente en effet un pouvoir athermique suiffsamment important (K=2,3) pour réduire dans une assez grande proportion la quantité de rayonnement calorifique susceptible de passer au travers de cette plaque. De tels vitrages remplacent avantageusement les vitrages doubles classiques qui sont, toutes proportions gardées, plus chers et plus fragiles.

Il est donc possible de faire usage de verres recouverts de $SnO_2$ traité ou non comme vitres chauffantes, par exemple de lunettes arrières de voitures. De plus, en ce qui concerne les autres glaces de voitures, les vitrages de l'invention sont également indiqués car, du fait de laur excellente réflectivité dans l'IR, ils contribuent à améliorer l'efficacité de la climatisation du véhicule.

Il a par ailleurs pu être observé que, placée dans une atmosphère d'humidité très importante, une plaque de verre portant un dépôt de $SnO_2$ ne se recouvrait pas d'une couche uniforme de buée, mais plutôt par une pluralité de gouttelettes altérant beaucoup moins la capacité de visibilité au travers du dépôt proprement dit et de la plaque de verre.

Cette propriété est évidemment particulièrement avantageuse dans le cas de plaques de verre destinées à constituer des vitres, notamment des vitres de véhicules et plus particulièrement des pare-brises et des lunettes arrière de voitures automobilies, d'autobus ou de camions.

Il est à remarquer que les vitrages obtenue par la mise en oeuvre du procédé selon l'invention peuvent avantageusement s'appliquer à l'horticulture (fabrication des vitrages des serres ou de couches froides).

On notera encore que le présent procédé peut être répété à volonté sur un substrat donné de manière à former un revêtement composé de plusieurs couches successives, la composition de celles-ci pouvant ne pas être identique. Ainsi, on peut, si désiré, recouvrir une couche de $SnO_2$ non traitée par une seconde couche traitée au HF. De même, on peut constituer un revêtement de 1 $\mu$m par dix couches successives de 100 nm chacune, les propriétés optiques et électriques de chaque couche n'étant pas nécessairement identiques.

Il est bien entendu que, pour un débit donné des réactifs, l'épaisseur d'une couche de revêtement dépend de la vitesse de défilement du substrat. Dans ces conditions, on peut, si désiré, multiplier les postes de réaction en juxtaposant côte-à-côte deux ou plusieurs dispositifs de revêtement tels que celui représenté au dessin. De cette manière, une seconde couche se superpose à la première avant que celle-ci ait eu le temps de refroidir, et ainsi de suite, ce qui conduit à un revêtement global particulièrement homogène.

Bien que, dans la description qui précède, on ait fait référence à des formes d'exécution d'installations dans lesquelles les plaques de verre à recouvrir par un dépôt de $SnO_2$ sont toujours placées à une distance de la buse correspondant à celle séparant cette buse et l'arête de convergence des parois latérales des trois tuyères de cette buse, on signalera que, en pratique, il sera possible de réduire légèrement cette distance de manière que le mélange des réactifs issus de ces tuyères se fasse à l'impact sur le verre en produisant un tourbillonnement local relativement intense favorisant ce mélange.

Exemple 1

L'exemple qui suit met en évidence les différences résultant d'une application de $SnO_2$ sur une plaque de verre en présence et en absence d'hydrogène.

On a utilisé l'installation telle que représentée à la figure 1 sans faire usage du barboteur à méthanol, la vanne 40 étant close. On a opéré dans les conditions suivantes:

| | |
|---|---|
| Température réactionnelle: | 590°C |
| Pression opérationnelle: | ambiante |
| Débit de la pompe 32: | 10 moles $H_2O$/h<br>$\simeq$250 litres/h de vapeur |
| Concentration de HF dans $H_2O$: | 2/98 (vol./vol.) |
| Composition du gaz porteur: | $H_2/N_2$ 40/60 (vol./vol.) |
| Température de l'évaporateur 33: | 140°C |
| Débit du gaz dans le flacon 21 ($SnCl_4$): | 370 litres/h |
| Température du flacon 21: | 90°C |
| Débit de $SnCl_4$: | 10 moles/h |
| Vitesse de défilement du verre V: | 1,2 m/mn |
| Vitesse d'aspiration des gaz de réaction: | 1500 litres/h |
| Débit du gaz porteur dans l'évaporateur 33: | 500 litres/h |

On a ainsi obtenu un dépôt présentant les caractéristiques suivantes: Epaisseur: 0,6 $\mu$m; résistance R□: 20 Ω; transparence 80%.

On a ensuite remplacé le mélange $H_2/N_2$ (gaz porteur) par de l'azote seul et, dans les mêmes conditions opératoires, on a obtenu un revêtement de caractéristiques suivantes: Epaisseur: 0,7 $\mu$m; résistance R□=100 Ω; transparence 80%.

Les conditions de travail ci-dessus correspondant approximativent à des proportions molaires de $H_2$ 48 moles%, $H_2O$ 26 moles%, et $SnCl_4$ 26 moles%, on a calculé thermodynamiquement les

proportions des réactifs et des produits de réaction à l'équilibre à 500 et 600°C et à pression ordinaire et on a trouvé les valeurs suivantes:

| Composants (moles%) | Avec hydrogène | | Sans hydrogène* | |
|---|---|---|---|---|
| | 500°C | 600°C | 500°C | 600°C |
| HCl | 43,7 | 43,8 | 64,17 | 67,26 |
| $H_2$ | 40,66 | 40,6 | — | — |
| $H_2O$ | 15,6 | 15,6 | 9,91 | 8,37 |
| $SnCl_2$ (g) | 13,1 | 21,9 | 0,0 | 0,0 |
| $SnCl_2$ (s) | 8,7 | 0,0 | 0,0 | 0,0 |
| $SnCl_4$ | 0,06 | 0,02 | 41,45 | 41,17 |
| $SnO_2$ | 0,0 | 0,0 | 16,1 | 18,8 |

*$H_2O$ 42 moles%, $SnCl_4$ 58 moles% (composition de départ).

Il est significatif qu'à l'équilibre, la réaction faite en présence d'$H_2$ ne fournit pas de $SnO_2$ et très peu de $SnCl_4$. Il est dès lors compréhensible que dans les conditions de travail (irréversibles), il se produise une réduction notable des composés stanniques en composés stanneux avec une augmentation marquée de la conductivité des dépôts.

Exemple 2
Depot d'un revetement multicouche

On a utilisé un dispositif de revêtement comportant une batterie de cinq buses de 1 m disposées parallèlement en cascade, chacune d'elles étant généralement conforme à la description donnée plus haut. Les canaux d'aspiration pour l'évacuation des gaz brûles ont été disposés de manière que chaque buse soit encadrée par un caniveau tel que représenté au dessin (16, 17). Les buses sont alimentées de réactifs comme décrit plus haut, avec cette différence que les quatre premières buses sont alimentées solidairement en ce qui concerne $H_2O$, la dernière buse étant alimentée séparément par une solution $HF/H_2O$ à 5%. Les tuyères centrales des cinq buses bont alimentées solidairement en $SnCl_4$.

On a travaillé dans les conditions suivantes:

| | |
|---|---|
| Température réactionnelle: | 590°C |
| Pression: | ambiante |
| Débit de la pompe à eau (unique pour les quatre premières buses): | 80 moles/h |
| Débit de la pompe à eau+HF (cinquième buse): | 20 moles/h |
| Composition du mélange $H_2O/HF$: | 98/2 (mole/mole) |
| Composition du gaz porteur (commune aux cinq buses): | $H_2/N_2$ 50/50 (vol./vol.) |
| Débit total du gaz porteur de l'eau dans les quatres premières buses: | 7000 litres/h |
| Débit du gas porteur de l'eau+HF: | 1800 litres/h |
| Température des évaporateurs: | 140°C |
| Débit du gaz porteur dans le récipient de $SnCl_4$: | 3500 litres/h |
| Température du récipient de $SnCl_4$: | 90°C |
| Débit de $SnCl_4$: | 50 moles/h |
| Taux d'aspiration total: | 15 $m^3/h$ |
| Vitesse de déplacement du verre: | 10 m/mn |

On a obtenu ainsi un revêtement comportant cinq couches superposées de 0,1 $\mu m$ chacune, la dernière seule étant traitée au fluor. Ce revêtement avait les propriétés suivantes: $R_\square=20\ \Omega$; réflectivité IR 55%; transparence 85%.

## Revendications

1. Procédé pour déposer sur un substrat de verre, porté à une température de 590°C environ à 650°C, un revêtement adhérent d'oxyde d'étain de résistivité de $5 . 10^{-3}$ Ohm.cm ou moins, suivant lequel on projette sur ce substrat, sous forme de courants de gaz laminaires se réunissant à proximité immédiate d'une portion de la surface dudit substrat, un composé volatil d'étain et de la vapeur d'eau dilués l'un et l'autre dans un flux propre de gaz porteur qui contient au moins 30% d'hydrogène (v/v), et suivant lequel on déplace le substrat par rapport ausdits courants de manière à obtenir ledit revêtement par formation d'un dépôt homogène d'oxyde d'étain successivement sur des zones renouvelées et jointives de la surface du substrat.

2. Procédé suivant la revendication 1, caractérisé par le fait qu'on ajoute au mélange de gaz de la

réaction du gaz fluorhydrique, ce dernier étant fourni en mélange avec de l'eau en proportion de 0,1 à 5% en poids ce celle-ci.

3. Procédé suivant l'une des revendications précédentes, caractérisé en ce que, après obtention d'une première couche d'oxyde d'étain, on répète l'opération de dépôt une seconde fois ou plusieurs fois, successivement, le revêtement ainsi obtenu étant formé de deux ou de plusieurs couches superposées d'oxyde d'étain ayant chacune une épaisseur de 10 à 500 nm.

**Patentansprüche**

1. Verfahren zum Beschichten eines auf eine Temperatur von etwa 590°C bis 650°C gebrachten Glassubstrats mit festhaftendem Zinnoxid mit einem spezifischen Leitungswiderstand von $5 \cdot 10^{-3}$ Ohm.cm oder weniger, dadurch gekennzeichnet, daß eine flüchtige Verbindung aus in einem reinen, mindestens 30% Wasserstoff (v/v) enthaltenden Trägergasstrom in Form von laminaren Gasströmen auf dieses Substrat aufgeschleudert wird, die sich in unmittelbarer Nähe eines Teils der Oberfläche dieses Substrats vereinigen, und daß das Substrat in bezug auf die genannten Ströme derart verschoben wird, daß die genannte Beschichtung durch Bildung einer nach und nach auf den erneuerten und aneinandergrenzenden Bereichen der Substratoberfläche stattfindenden homogenen Zinnoxidschicht erhalten wird.

2. Verfahren nach Anspruch 1, dadurch gekennzeichnet, daß der Gasmischung aus der Reaktion Fluorwasserstoffgas beigemengt wird, wobei letzteres in Mischung mit Wasser in einem Verhältnis von 0,1 bis 5 Gew% desselben geliefert wird.

3. Verfahren nach einem der Ansprüche 1 oder 2, dadurch gekennzeichnet, daß nach Erhalt einer ersten Zinnoxidschicht der Ablagerungsvorgang ein zweites oder mehrere Male nacheinander wiederholt wird, wobei dann die dadurch erhaltene Beschichtung aus zwei oder mehreren übereinandergelagerten Zinnoxidschichten besteht, die jeweils eine Dicke von 10 bis 500 nm aufweisen.

**Claims**

1. Method for depositing on glass substrate heated to a temperature of about 590°C to 650°C an adherent tin oxide coating having a resistivity of $5 \times 10^{-3}$ Ohm.cm or less, which comprises projecting on this substrate, under the form of laminar gas streams meeting in close proximity to a portion of said substrate's surface, a volatile tin compound and water vapor both diluted in separate own flows of carrier gas containing at least 30% of hydrogen (v/v) and which comprises displacing the substrate with regard to said streams so as to obtain said coating by formation of a homogeneous tin oxide deposit that takes place successively on progressively renewed and jointed areas of the substrate's surface.

2. Method according to claim 1, characterized by the fact that there is added to the reaction gas mixture hydrofluoric gas, the latter being provided as a mixture with water in a proportion of 0.1 to 5% by weight thereof.

3. Method according to one of the preceding claims, characterized by the fact that after when a first layer of tin oxide is obtained, the deposition operation is repeated another time or several times, the coating thus obtained being formed of two or several superimposed layers of tin oxide each being 10 to 500 nm thick.

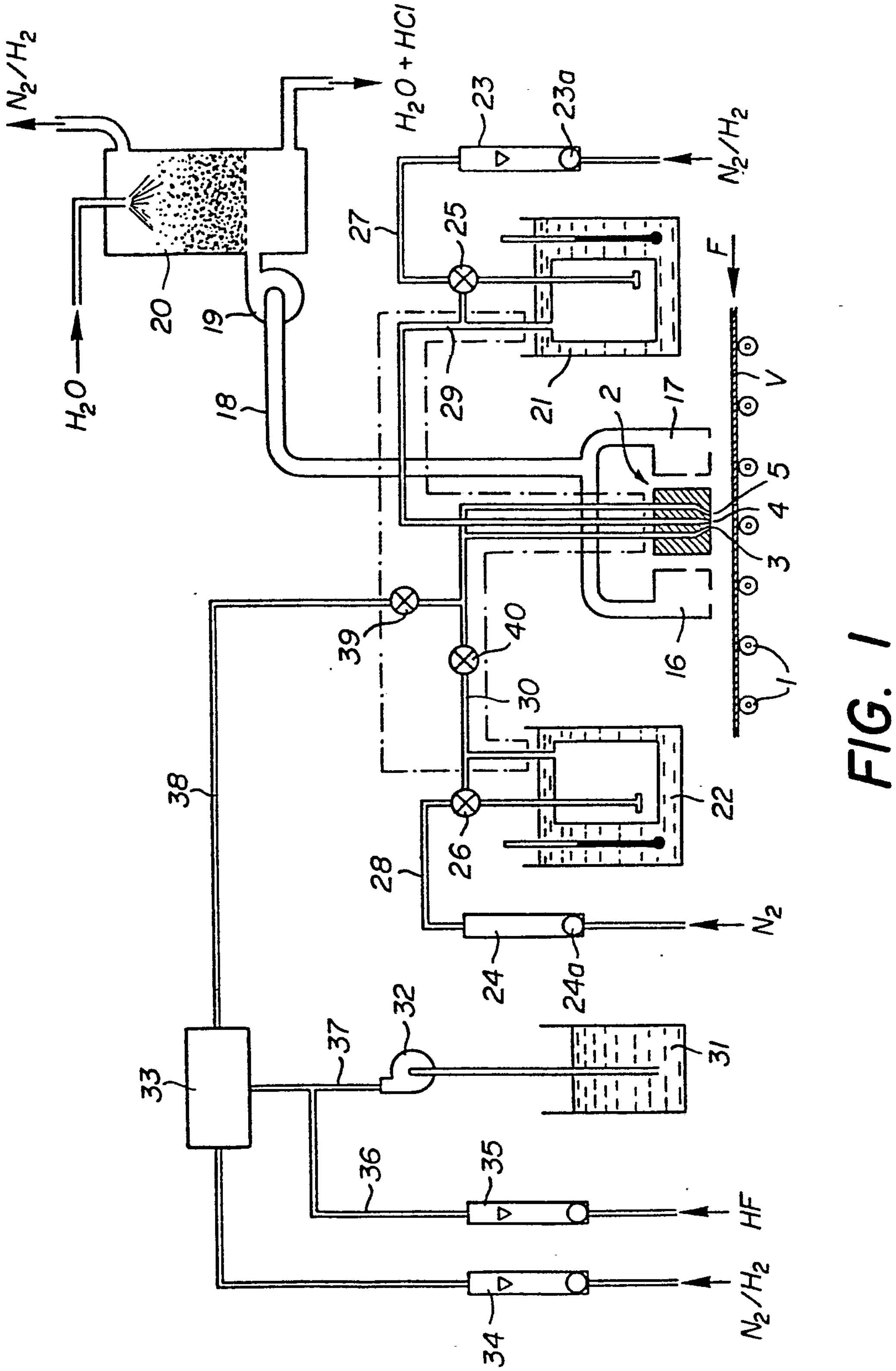
N2/H2
H2O + HCl
23
23a
H2O
20
19
18
27
25
N2/H2
F
29
21
2
17
V
5
4
3
16
1
39
40
30
38
22
26
28
24
24a
N2
33
37
32
31
36
35
HF
34
N2/H2

FIG. 1

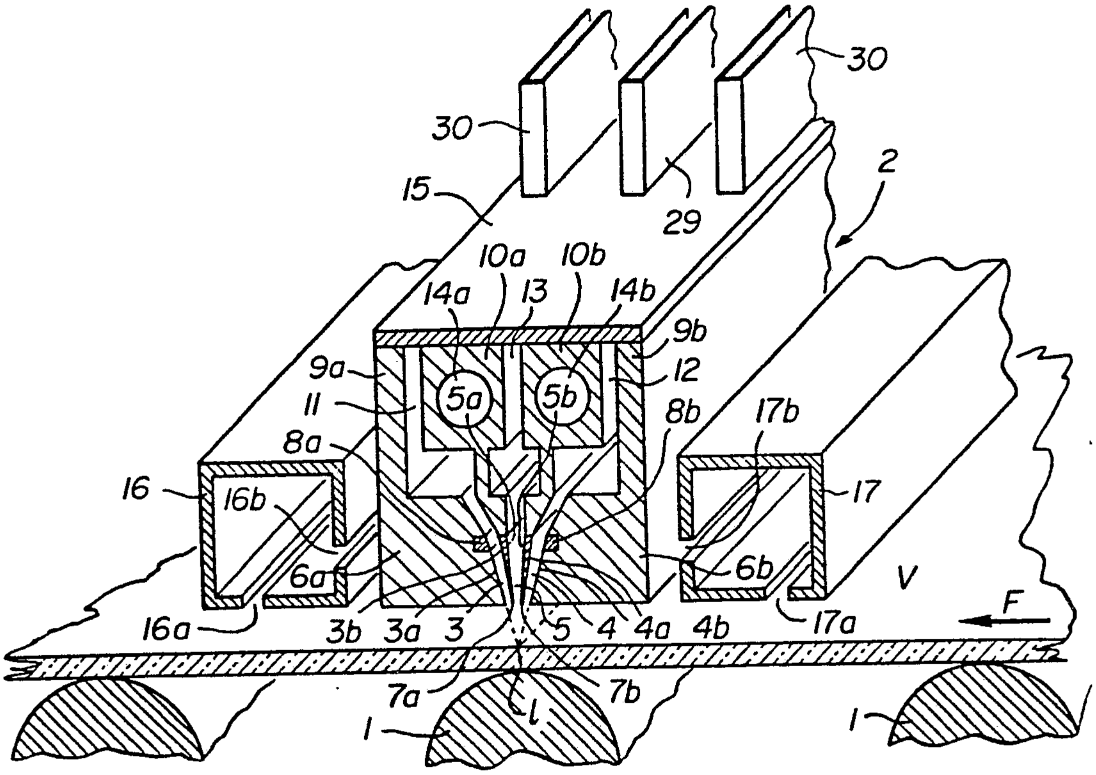
30
30
2
15
29
10a
10b
14a
13
14b
9a
9b
12
11
5a
5b
8a
8b
17b
16
16b
17
6a
6b
V
F
16a
3b
3a
3
5
4
4a
4b
17a
7a
7b
l
1
1

FIG. 2